# EUROPEAN PATENT APPLICATION

(11) **EP 4 362 629 A1**
(43) Date of publication of application: **01.05.2024**
(21) Application number: 22929386.5
(22) Date of filing: 04.03.2022
(51) Int. Cl.: H10K 50/00, H10K 71/00, H10K 85/00

(54) **PEROVSKITE SOLAR CELL AND PREPARATION METHOD THEREFOR**

(71) Applicant: Contemporary Amperex Technology Co., Limited, Ningde, Fujian 352100 (CN)
(72) Inventor: TU, Bao, Ningde, Fujian 352100 (CN); GUO, Wenming, Ningde, Fujian 352100 (CN); CHEN, Changsong, Ningde, Fujian 352100 (CN); GUO, Yongsheng, Ningde, Fujian 352100 (CN); CHEN, Guodong, Ningde, Fujian 352100 (CN); OUYANG, Chuying, Ningde, Fujian 352100 (CN)
(74) Representative: Ran, Handong
(86) International application number: PCT/CN2022/079372
(87) International publication number: WO 2023/164943

(57) **Abstract**

The present application provides a perovskite solar cell, comprising a transparent conductive glass substrate, an electron transport layer, a perovskite light-absorbing layer, a hole transport layer and an electrode. A metal fluoride layer is disposed between the electron transport layer and the perovskite light-absorbing layer, and the thickness of the metal fluoride layer is greater than 0 and less than or equal to 3 nm, optionally 1 nm-3 nm. The present application also provides a method for preparing a perovskite solar cell.

## Description

### TECHNICAL FIELD

The present application relates to the technical field of solar cells, and in particular, to a perovskite solar cell and a method for preparing the same.

### BACKGROUND

With the rapid development in the field of new energy sources, solar cells have been widely used in fields such as military, aerospace, industry, commerce, agriculture, and communications. Perovskite solar cells have gradually become a hotspot in the research of new generation solar cells due to their advantages such as high photoelectric conversion efficiency, simple manufacturing process, and low production cost and material cost.

Since the perovskite solar cells have achieved great development, higher requirements have been placed on its photoelectric conversion efficiency and long-term service stability. According to the analysis, the improvement of the subsequent photoelectric conversion efficiency is mainly based on the improvement of the fill factor. The fill factor of a device is mainly related to the overall contact resistance and parallel resistance of the device: the fill factor increases with a decreasing contact resistance and an increasing parallel resistance. However, there remains a need for further improvements in the contact resistance of current perovskite solar cells.

### SUMMARY

In view of the above problems, an objective of the present application is to provide a perovskite solar cell with low contact resistance and high photoelectric conversion efficiency.

In order to achieve the above objective, the application provides a perovskite solar cell and a method for preparing the same.

A first aspect of the present application provides a perovskite solar cell, which includes a transparent conductive glass substrate, an electron transport layer, a perovskite light-absorbing layer, a hole transport layer, and an electrode, wherein,

a metal fluoride layer is disposed between the electron transport layer and the perovskite light-absorbing layer, and a thickness of the metal fluoride layer is greater than 0 and less than or equal to 3 nm, optionally 1 nm-3 nm.

Accordingly, by disposing an ultra-thin metal fluoride layer between the electron transport layer and the perovskite light-absorbing layer, the application reduces the contact resistance of the perovskite solar cell and improves the fill factor thereof, thereby improving the photoelectric conversion efficiency of the perovskite solar cell.

In any of the embodiments, the transparent conductive glass substrate, the electron transport layer, the metal fluoride layer, the perovskite light-absorbing layer, the hole transport layer, and the electrode are sequentially arranged from bottom to top.

In any of the embodiments, the transparent conductive glass substrate, the hole transport layer, the perovskite light-absorbing layer, the metal fluoride layer, the electron transport layer, and the electrode are sequentially arranged from bottom to top.

In any of the embodiments, the metal fluoride layer is one or more selected from of an alkali metal fluoride and an alkaline earth metal fluoride. Optionally, the metal fluoride layer is one or more selected from of lithium fluoride, sodium fluoride, potassium fluoride, rubidium fluoride, cesium fluoride, magnesium fluoride, calcium fluoride, strontium fluoride, and barium fluoride.

A second aspect of the present application provides a method for preparing a perovskite solar cell, which includes the following steps:
Step 1: providing a transparent conductive glass substrate;
Step 2: preparing an electron transport layer on the transparent conductive glass substrate;
Step 3: depositing a metal fluoride layer on the electron transport layer by evaporation;
Step 4: preparing a perovskite light-absorbing layer on the metal fluoride layer;
Step 5: preparing a hole transport layer on the perovskite light-absorbing layer; and
Step 6: preparing an electrode on the hole transport layer to obtain a perovskite solar cell,
wherein the perovskite solar cell includes a transparent conductive glass substrate, an electron transport layer, a perovskite light-absorbing layer, a hole transport layer, and an electrode, and a metal fluoride layer is disposed between the electron transport layer and the perovskite light-absorbing layer, a thickness of the metal fluoride layer is greater than 0 and less than or equal to 3 nm, optionally 1 nm-3 nm.

A third aspect of the present application provides a method for preparing a perovskite solar cell, which includes the following steps:
Step 1: providing a transparent conductive glass substrate;
Step 2: preparing a hole transport layer on the transparent conductive glass substrate;
Step 3: preparing a perovskite light-absorbing layer on the hole transport layer;
Step 4: depositing a metal fluoride layer on the perovskite light-absorbing layer by evaporation;
Step 5: preparing an electron transport layer on the metal fluoride layer; and
Step 6: preparing an electrode on the electron transport layer to obtain a perovskite solar cell,
wherein the perovskite solar cell includes a transparent conductive glass substrate, an electron transport layer, a perovskite light-absorbing layer, a hole transport layer, and an electrode, and a metal fluoride layer is disposed between the electron transport layer and the perovskite light-absorbing layer, a thickness of the metal fluoride layer is greater than 0 and less than or equal to 3 nm, optionally 1 nm-3 nm.

Accordingly, the method of the application can prepare the perovskite solar cell of the application with simple steps, low-cost, and high efficiency.

In any of the embodiments, in the method in the second aspect of the application and the method in the third aspect of the application, an evaporation rate when depositing the metal fluoride layer is 0.01-0.05 Å/s. The evaporation rate within the given range can result in a dense and uniform metal fluoride layer.

### BRIEF DESCRIPTION OF THE DRAWINGS

FIG. 1 is a schematic diagram of the perovskite solar cell according to an embodiment of the present application; and
FIG. 2 is a schematic diagram of the perovskite solar cell according to another embodiment of the present application.

### Reference numbers in the drawings are as follows:

101 transparent conductive glass substrate; 102 hole transport layer; 103 perovskite light-absorbing layer; 104 metal fluoride layer; 105 electron transport layer; 106 electrode; 201 transparent conductive glass substrate; 202 electron transport layer; 203 metal fluoride layer; 204 perovskite light-absorbing layer; 205 hole transport layer; and 206 electrode.

### DETAILED DESCRIPTION OF THE EMBODIMENTS

Hereinafter, embodiments of the perovskite solar cell and a method for preparing the same of the present application will be specifically disclosed in detail with reference to the accompanying drawings. However, unnecessary detailed description may be omitted. For example, detailed descriptions of well-known items and repeated descriptions of substantially the same configurations may be omitted. This is to avoid the following description from becoming unnecessarily lengthy and to facilitate the understanding of those skilled in the art. In addition, the drawings and the following descriptions are provided for those skilled in the art to fully understand the present application, and are not intended to limit the subject matter described in the claims.

The "range" disclosed in the application is defined in the form of lower limit and upper limit, and the given range is limited by selecting a lower limit and an upper limit, and the selected lower limit and upper limit define the boundary of a special range. Ranges defined in this manner may be inclusive or exclusive and may be combined arbitrarily, i.e., any lower limit may be combined with any upper limit to form a range. For example, if ranges of 60-120 and 80-110 are listed for a particular parameter, it is understood that ranges of 60-110 and 80-120 are contemplated. Additionally, if the minimum range values 1 and 2 are listed, and if the maximum range values 3, 4, and 5 are listed, the following ranges are all expected: 1-3, 1-4, 1-5, 2- 3, 2-4, and 2-5. In this application, unless otherwise stated, the numerical range "a-b" represents an abbreviated representation of any combination of real numbers between a and b, where a and b are both real numbers. For example, the numerical range "0-5" indicates that all real numbers between "0-5" have been listed in this article, and "0-5" is only an abbreviated representation of the combination of these values. In addition, when expressing that a certain parameter is an integer ≥ 2, it is equivalent to disclosing that the parameter is an integer such as 2, 3, 4, 5, 6, 7, 8, 9, 10, 11, 12, etc.

Unless otherwise specified, all implementation modes and optional implementation modes of the present application may be combined with each other to form new technical proposals.

Unless otherwise specified, all technical features and optional technical features of the present application may be combined with each other to form new technical proposals.

Unless otherwise specified, all the steps in the present application may be performed sequentially or randomly, preferably sequentially. For example, the method including steps (a) and (b) means that the method may include steps (a) and (b) performed in sequence, and may also include steps (b) and (a) performed in sequence. For example, mentioning that the method may also include step (c), means that step (c) may be added to the method in any order, for example, the method may include steps (a), (b) and (c), may also include steps (a), (c) and (b), and may also include steps (c), (a) and (b).

Unless otherwise specified, "include" and "comprise" mentioned in the application represent an open type or a closed type. For example, the "include" and "comprise" may mean that other components not listed may be included or comprised, or only listed components may be included or comprised.

Unless otherwise specified, in this application, the term "or" is inclusive. For example, the phrase "A or B" means "A, B, or both A and B." More specifically, the condition "A or B" is satisfied by either: A is true (or exists) and B is false (or does not exist); A is false (or does not exist) and B is true (or exists); or both A and B are true (or exist).

The photoelectric conversion efficiency of existing perovskite solar cells has been as high as 25.5%, and the current density and open circuit voltage thereof have all been greatly improved. It is analyzed that the promotion of subsequent photoelectric conversion efficiency is mainly based on the improvement of the fill factor. The fill factor of the device is mainly related to the overall contact resistance and parallel resistance of the device: the fill factor increases with a decreasing contact resistance and an increasing parallel resistance. At present, the parallel resistance is mainly improved by reducing the overall defect state density of the device, and improving the conductivity and mobility is an effective means to reduce the contact resistance.

After a large number of experiments, the inventors of the present application have found that when an ultra-thin metal fluoride layer is disposed between the electron transport layer and the perovskite light-absorbing layer, the contact resistance of the perovskite solar cell can be reduced, thereby improving the fill factor thereof.

In one embodiment of the present application, proposed is a perovskite solar cell, including a transparent conductive glass substrate, an electron transport layer, a perovskite light-absorbing layer, a hole transport layer, and an electrode, in which,
a metal fluoride layer is disposed between the electron transport layer and the perovskite light-absorbing layer, a thickness of the metal fluoride layer is greater than 0 and less than or equal to 3 nm, optionally 1 nm-3 nm.

Although mechanism is not yet clear, the inventors find unexpectedly: in the present application, the ultra-thin metal fluoride layer disposed between the electron transport layer and the perovskite light-absorbing layer, while carrying out n-type doping to the electron transport layer, at the same time, it can effectively eliminate the residual Schottky barrier between the electron transport layer and the perovskite light-absorbing layer, thereby reducing the contact resistance of the perovskite solar cell, increasing its fill factor, and eventually improving the photoelectric conversion efficiency of the perovskite solar cell.

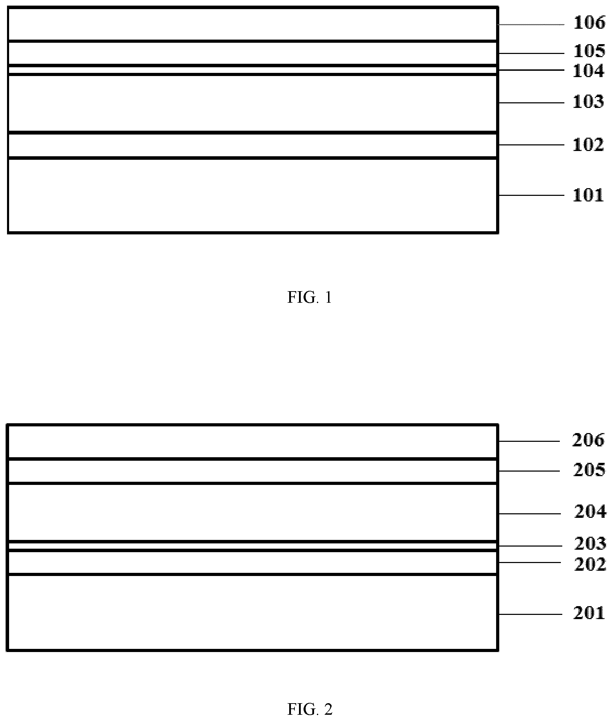

In some embodiments, the transparent conductive glass substrate 101, the hole transport layer 102, the perovskite light-absorbing layer 103, the metal fluoride layer 104, the electron transport layer 105, and the electrode 106 are arranged sequentially from bottom to top, as shown in FIG. 1. Perovskite solar cells with this configuration are often referred to as inverted perovskite solar cells.

In some embodiments, the transparent conductive glass substrate 201, the electron transport layer 202, the metal fluoride layer 203, the perovskite light-absorbing layer 204, the hole transport layer 205, and the electrode 206 are arranged sequentially from bottom to top, as shown in FIG. 2. Perovskite solar cells with this configuration are often referred to as regular perovskite solar cells.

In the embodiment of the present application, the thickness of the metal fluoride layer is detected by the built-in film thickness detector of the vacuum evaporation equipment.

In some embodiments, the metal fluoride layer is one or more selected from of alkali metal fluorides and alkaline earth metal fluorides, optionally, the metal fluoride layer is one or more selected from of lithium fluoride, sodium fluoride, potassium fluoride, rubidium fluoride, cesium fluoride, magnesium fluoride, calcium fluoride, strontium fluoride, and barium fluoride.

In some embodiments, the metal fluoride layer may be a single metal fluoride, or a mixture of a plurality of metal fluorides.

In some embodiments, the transparent conductive glass substrate includes glass and a transparent conductive oxide, and the transparent conductive oxide is selected from fluorine-doped tin oxide (FTO), indium tin oxide (ITO), aluminum-doped zinc oxide (AZO), boron-doped zinc oxide (BZO), indium zinc oxide (IZO), and the like, a thickness of the glass is 1.1 mm-2.2 mm, and a thickness of the transparent conductive oxide is 100 nm-800 nm.

In some embodiments, a chemical formula of the material of the perovskite light-absorbing layer is ABX₃ or A₂CDX₆, in which A is an inorganic or organic or organic-inorganic mixed cation, and optionally at least one of a methylamino group (CH₃NH₃⁺) (MA⁺), a formamidinyl group (HC(NH₂)₂⁺) (FA⁺), a cesium ion (Cs⁺), and rubidium (Rb⁺), further optionally a methylamino group (CH₃NH₃⁺) or a formamidinyl group (HC(NH₂)₂⁺); B is an inorganic or organic or organic-inorganic mixed cation, optionally at least one of divalent metal ions Pb²⁺ and Sn²⁺; C is an inorganic or organic or organic-inorganic mixed cation, optionally a monovalent metal ion Ag⁺, and the like; D is an inorganic or organic or organic-inorganic mixed cation, optionally a trivalent metal ion Bi³⁺, and the like; X is an inorganic or organic or organic-inorganic mixed anion, optionally one or more of a halogen anion and an acetate ion, further optionally a chloride ion (Cl⁻), bromide ion (Br⁻), or iodide Ion (I⁻).

In some embodiments, the material of the perovskite light-absorbing layer is selected from FA_{0.83}Cs_{0.17}PbI₃ and FAPbI₃.

In some embodiments, the band gap of the perovskite light-absorbing layer is 1.20 eV-2.30 eV

In some embodiments, the thickness of the perovskite light-absorbing layer is 200 nm-1000 nm.

In some embodiments, the material of the electron transport layer is at least one of the following materials and derivatives thereof and doped or passivated materials thereof: [6,6]-phenyl-C₆₁-butyric acid methyl ester (PC₆₁BM), [6,6]-phenyl-C₇₁-butyric acid methyl ester (PC₇₁BM), fullerene C60 (C60), fullerene C70 (C70), tin dioxide (SnO₂), zinc oxide (ZnO), and the like.

In some embodiments, the thickness of the electron transporting layer is 20 nm-50 nm.

In some embodiments, the material of the hole transport layer is at least one of the following materials and derivatives thereof and doped or passivated materials thereof: Poly[bis(4-phenyl)(2,4,6-trimethylphenyl)amine] (PTAA), 2,2',7,7'-tetrakis[N,N-bis(4-methoxyphenyl)amino]-9,9'-spirobifluorene (Spiro-OMeTAD), poly-3-hexylthiophene (P3HT), triptycene-cored triphenylamine (H101), 3,4-ethylenedioxythiophene-methoxytriphenylamine (EDOT-OMeTPA), N-(4-aminophenyl)carbazole-spirobifluorene (CzPAF-SBF), poly(3,4-ethylenedioxythiophene): polystyrene sulfonate (PEDOT:PSS), polythiophene, nickel oxide (NiOx), molybdenum oxide (MoOs), cuprous iodide (CuI), cuprous oxide (Cu₂O), and the like.

In some embodiments, the thickness of the hole transport layer is 10 nm-40 nm in the inverted perovskite solar cell, and 100 nm-300 nm in the regular perovskite solar cell.

In some embodiments, the material of the electrode is an organic or inorganic or organic-inorganic mixed conductive material, optionally Ag, Cu, C, Au, Al, ITO, AZO, BZO, or IZO.

In some embodiments, the thickness of the electrode is 60 nm-80 nm.

In some embodiments, corresponding modification layers may be inserted between the above layers.

In one embodiment of the present application proposes a method for preparing a perovskite solar cell, including the following steps:
Step 1: providing a transparent conductive glass substrate;
Step 2: preparing an electron transport layer on the transparent conductive glass substrate;
Step 3: depositing a metal fluoride layer on the electron transport layer by evaporation;
Step 4: preparing a perovskite light-absorbing layer on the metal fluoride layer;
Step 5: preparing a hole transport layer on the perovskite light-absorbing layer; and
Step 6: preparing an electrode on the hole transport layer to obtain a perovskite solar cell,
wherein the perovskite solar cell includes a transparent conductive glass substrate, an electron transport layer, a perovskite light-absorbing layer, a hole transport layer, and an electrode, and a metal fluoride layer is disposed between the electron transport layer and the perovskite light-absorbing layer, a thickness of the metal fluoride layer is greater than 0 and less than or equal to 3 nm, optionally 1 nm-3 nm.

In one embodiment of the present application proposes a method for preparing a perovskite solar cell, including the following steps:
Step 1: providing a transparent conductive glass substrate;
Step 2: preparing a hole transport layer on the transparent conductive glass substrate;
Step 3: preparing a perovskite light-absorbing layer on the hole transport layer;
Step 4: depositing a metal fluoride layer on the perovskite light-absorbing layer by evaporation;
Step 5: preparing an electron transport layer on the metal fluoride layer; and
Step 6: preparing an electrode on the electron transport layer to obtain a perovskite solar cell,
wherein the perovskite solar cell includes a transparent conductive glass substrate, an electron transport layer, a perovskite light-absorbing layer, a hole transport layer, and an electrode, and a metal fluoride layer is disposed between the electron transport layer and the perovskite light-absorbing layer, a thickness of the metal fluoride layer is greater than 0 and less than or equal to 3 nm, optionally 1 nm-3 nm.

The method of the application can prepare the perovskite solar cell of the application with simple steps, low-cost, and high efficiency.

In some embodiments, an evaporation rate when depositing the metal fluoride layer is 0.01-0.05 Å/s.

The evaporation rate within the given range can result in a dense and uniform metal fluoride layer. If the evaporation rate is too fast, an island-like metal fluoride layer may be obtained, which will affect the deposition effect. If the evaporation rate is too slow, the evaporation time will be too long, which will easily cause the decomposition or peeling of the base layer. Therefore, a continuous and uniform metal fluoride layer may not be formed if the evaporation rate is too fast or too slow.

In some embodiments, in order to deposit the metal fluoride layer at a stable evaporation rate, the 1 nm metal fluoride obtained by the initial evaporation is discarded during the evaporation process. This process is realized by a built-in baffle plate in the evaporation equipment, and the baffle plate may be opened and closed through the operation of buttons on the equipment. Before the initial evaporation of metal fluoride, the baffle plate is closed, 1 nm of metal fluoride is vapor-deposited, then the baffle plate is opened, and 1 nm of metal fluoride is vapor-deposited on the wafer. Afterward, the baffle plate is closed again, and evacuation is carried out for 30 minutes before performing subsequent operations to prevent the interference of the metal fluoride evaporation material.

In some embodiments, the preparation of the hole transport layer, the perovskite light-absorbing layer, the electron transport layer, and the electrode can be carried out by conventional methods in the art.

### Examples

Hereinafter, examples of the present application will be described. The examples described below are exemplary and are only used for explaining the present application, and should not be construed as limiting the present application. If no specific technique or condition is indicated in the examples, it shall be carried out according to the technique or condition described in the literature in the art or according to the product specification. The reagents or instruments used without indication of the manufacturer were all commercially available conventional products.

### Example 1-1

In step 1: an ITO conductive glass with a size of 2.0 cm × 2.0 cm (the total thickness was 1.1 mm, of which the thickness of ITO was 100 nm) was selected, and 0.35 cm of ITO was removed from opposite ends by laser etching to expose the glass substrate; the etched ITO conductive glass was ultrasonically cleaned 3 times in sequence with water, acetone, and isopropanol; the ITO conductive glass after ultrasonic cleaning was blown to dry the solvent under a nitrogen gun, and placed in a UV ozone machine for further cleaning;
In step 2: 2 mg/mL chlorobenzene solution of PTAA was spin-coated at 5000 rpm on the ITO conductive glass treated with UV ozone, and annealed on a hot stage at 100°C for 10 minutes to obtain a hole transport layer with a thickness of 20 nm;
In step 3: a perovskite precursor solution was spin-coated on the prepared hole transport layer at 5000 rpm, and the perovskite precursor solution contained N,N-dimethylformamide and dimethyl sulfoxide in a volume ratio of 4:1 as solvents, lead iodide at 1.2 mol/L, formamidine hydroiodide at 1.0 mol/L, and cesium iodide at 0.2 mol/L; the coated hole transport layer was annealed at 100°C for 30 minutes and cooled to room temperature to obtain a FA_{0.83}Cs_{0.17}PbI₃ perovskite light-absorbing layer with a thickness of 550 nm;
In step 4: 1 nm of lithium fluoride was deposited on the perovskite light-absorbing layer at an evaporation rate of 0.02 Å/s at a vacuum degree of 5 × 10⁻⁴ Pa in a vacuum evaporation machine to obtain a metal fluoride layer; during the evaporation process, 1 nm lithium fluoride obtained by the initial evaporation was discarded, and after 1 nm lithium fluoride was deposited, the baffle plate was closed, and then subsequent operations were performed after evacuating for 30 minutes;
In step 5: 30 nm of fullerene C60 was then deposited on the prepared metal fluoride layer at a rate of 0.05 Å/s in the vacuum evaporation machine to obtain an electron transport layer; and
In step 6: 80 nm of Cu was then deposited on the prepared electron transport layer at a rate of 0.1 Å/s in the vacuum evaporation machine to obtain an electrode;
The perovskite solar cell according to the present application was obtained through the above steps.

### Examples 1-2 and 1-3

The overall preparations of the perovskite solar cell were carried out with reference to Example 1-1, except that, in step 4, the thicknesses of the metal fluoride layer were 2 nm and 3 nm, respectively.

### Example 1-4

The overall preparation of the perovskite solar cell was carried out with reference to Example 1-1, except that, in step 4, the metal fluoride was potassium fluoride.

### Example 1-5

The overall preparation of the perovskite solar cell was carried out with reference to Example 1-1, except that, in step 4, the metal fluoride was magnesium fluoride.

### Comparative Example 1-1

The overall preparation of the perovskite solar cell was carried out with reference to Example 1-1, except that, step 4 was not carried out.

### Comparative Example 1-2

The overall preparation of the perovskite solar cell was carried out with reference to Example 1-1, except that, in step 4, the thickness of the metal fluoride layer was 4 nm.

### Example 2-1

In step 1: an ITO conductive glass with a size of 2.0 cm × 2.0 cm (the total thickness was 1.1 mm, of which the thickness of ITO was 100 nm) was selected, and 0.35 cm of ITO was removed from opposite ends by laser etching to expose the glass substrate; the etched ITO conductive glass was ultrasonically cleaned 3 times in sequence with water, acetone, and isopropanol; the ITO conductive glass after ultrasonic cleaning was blown to dry the solvent under a nitrogen gun, and placed in a UV ozone machine for further cleaning;
In step 2: 15 wt% of SnO₂ colloidal solution was spin-coated at a rate of 4000 rpm on the ITO substrate treated with UV ozone, and annealed on a hot stage at 150°C for 10 minutes to obtain an electron transport layer with a thickness of 30 nm;
In step 3: 1 nm of lithium fluoride was deposited on the electron transport layer at a rate of 0.02 Å/s under a vacuum degree of 5 × 10⁻⁴ Pa in a vacuum evaporation machine, to obtain a metal fluoride layer;
In step 4: a perovskite precursor solution was spin-coated on the prepared metal fluoride layer at 5000 rpm, and the perovskite precursor solution contained N,N-dimethylformamide and dimethyl sulfoxide in a volume ratio of 4:1 as solvents, lead iodide at 1.2 mol/L, formamidine hydroiodide at 1.0 mol/L, and cesium iodide at 0.2 mol/L; the coated layer was annealed at 100°C for 30 minutes and cooled to room temperature to obtain a FA_{0.83}Cs_{0.17}PbI₃ perovskite light-absorbing layer with a thickness of 550 nm;
In step 5: a 73 mg/mL solution of Spiro-OMeTAD in chlorobenzene was spin-coated at a rate of 3000 rpm on the prepared perovskite light-absorbing layer to obtain a hole transport layer with a thickness of 200 nm; and
In step 6: 80 nm of Au was deposited on the hole transport layer at a rate of 0.1 Å/s under a vacuum degree of 5 × 10⁻⁴ Pa in the vacuum evaporation machine, to obtain an electrode;
The perovskite solar cell according to the present application was obtained through the above steps.

### Examples 2-2 and 2-3

The overall preparations of the perovskite solar cell were carried out with reference to Example 2-1, except that, in step 3, the thicknesses of the metal fluoride layer were 2 nm and 3 nm, respectively.

### Example 2-4

The overall preparation of the perovskite solar cell was carried out with reference to Example 2-1, except that, in step 3, the metal fluoride was cesium fluoride.

### Example 2-5

The overall preparation of the perovskite solar cell was carried out with reference to Example 2-1, except that, in step 3, the metal fluoride was magnesium fluoride.

### Comparative Example 2-1

The overall preparation of the perovskite solar cell was carried out with reference to Example 2-1, except that, step 3 was not carried out.

### Comparative Example 2-2

The overall preparation of the perovskite solar cell was carried out with reference to Example 2-1, except that, in step 3, the thickness of the metal fluoride layer was 4 nm.

### Examples 3-1 and 3-2

The overall preparations of the perovskite solar cell were respectively carried out with reference to Example 1-1, except that, in step 4, the evaporation rates of metal fluorides were 0.01 Å/s and 0.05 Å/s, respectively.

### Comparative Examples 3-1 and 3-2

The overall preparations of the perovskite solar cell were respectively carried out with reference to Example 1-1, except that, in step 4, the evaporation rates of metal fluorides were 0.005 Å/s and 0.06 Å/s, respectively.

### Examples 4-1 and 4-2

The overall preparations of the perovskite solar cell were carried out with reference to Example 2-1, except that, in step 3, the evaporation rates of metal fluorides were 0.01 Å/s and 0.05 Å/s, respectively.

### Comparative Examples 4-1 and 4-2

The overall preparations of the perovskite solar cell were respectively carried out with reference to Example 2-1, except that, in step 3, the evaporation rates of metal fluorides were 0.005 Å/s and 0.06 Å/s, respectively.

### Test methods

### 1. Contact resistance of the perovskite solar cells

Performances of the cells were tested under the irradiation of standard simulated sunlight (AM 1.5G, 100 mW/cm²) to obtain the I-V curves, and the contact resistance were automatically read by a computer according to the data.

### 2. Photoelectric conversion efficiency of the perovskite solar cells

Performances of the cells were tested under the irradiation of standard simulated sunlight (AM 1.5G, 100 mW/cm²) to obtain the I-V curves. According to the I-V curves and the data fed back by the test equipment, the short-circuit current Jsc (in mA/cm²), the open-circuit voltage Voc (in V), the maximum light output current Jmpp (in mA), and the maximum light output voltage Vmpp (in V) can be obtained. The fill factor FF, in %, of the cells were calculated according to the formula FF=Jsc×Voc/(Jmpp×Vmpp). The photoelectric conversion efficiency PCE, in %, of the cells were calculated according to the formula PCE=Jsc×Voc×FF/Pw; Pw is the input power, in mW.

The perovskite solar cells obtained in the above-mentioned examples and comparative examples were tested respectively according to the above-mentioned process, and the specific numerical values are shown in Table 1-Table 4.

**Table 1 Influence of the metal fluoride layer on performances of inverted perovskite solar cells**

| Examples | Parameters of perovskite solar cell | | Performances of perovskite solar cell | | | | |
|---|---|---|---|---|---|---|---|
| | Metal fluoride | Thickness of metal fluoride (nm) | Contact resistance (ohm) | Jsc (mA·cm⁻²) | Voc (V) | FF (%) | Photoelectric conversion efficiency (%) |
| Example 1-1 | Lithium fluoride | 1 | 100.12 | 23.43 | 1.09 | 79.96 | 20.42 |
| Example 1-2 | Lithium fluoride | 2 | 73.24 | 23.51 | 1.1 | 81.86 | 21.17 |
| Example 1-3 | Lithium fluoride | 3 | 102.19 | 23.44 | 1.1 | 79.66 | 20.54 |
| Example 1-4 | Potassium fluoride | 1 | 84.71 | 23.41 | 1.1 | 81.43 | 20.97 |
| Example 1-5 | Magnesium fluoride | 1 | 93.28 | 23.49 | 1.09 | 80.26 | 20.55 |
| Comparative Example 1-1 | / | / | 143.71 | 23.5 | 1.1 | 77.83 | 20.12 |
| Comparative Example 1-2 | Lithium fluoride | 4 | 153.53 | 23.51 | 1.10 | 77.37 | 20.01 |

**Table 2 Influence of the metal fluoride layer on performances of regular perovskite solar cells**

| Examples | Parameters of perovskite solar cell | | Performances of perovskite solar cell | | | | |
|---|---|---|---|---|---|---|---|
| | Metal fluoride | Thickness of metal fluoride (nm) | Contact resistance (ohm) | Jsc (mA·cm⁻²) | Voc (V) | FF (%) | Photoelectric conversion efficiency (%) |
| Example 2-1 | Lithium fluoride | 1 | 73.42 | 24.57 | 1.14 | 82.47 | 23.10 |
| Example 2-2 | Lithium fluoride | 2 | 42.12 | 24.66 | 1.15 | 83.00 | 23.54 |
| Example 2-3 | Lithium fluoride | 3 | 77.66 | 24.49 | 1.14 | 82.38 | 23.00 |
| Example 2-4 | Cesium fluoride | 1 | 60.31 | 24.50 | 1.14 | 82.84 | 23.14 |
| Example 2-5 | Magnesium fluoride | 1 | 67.82 | 24.67 | 1.14 | 82.52 | 23.21 |
| Comparative Example 2-1 | / | / | 82.10 | 24.60 | 1.13 | 81.94 | 22.78 |
| Comparative Example 2-2 | Lithium fluoride | 4 | 90.04 | 24.50 | 1.14 | 81.74 | 22.83 |

**Table 3 Influence of evaporation rate of the metal fluoride layer on performances of inverted perovskite solar cells**

| Examples | Evaporation rate (Å/s) | Performances of perovskite solar cell | | | | |
|---|---|---|---|---|---|---|
| | | Contact resistance (ohm) | Jsc (mA·cm⁻²) | Voc (V) | FF (%) | Photoelectric conversion efficiency (%) |
| Example 1-1 | 0.02 | 100.12 | 23.43 | 1.09 | 79.96 | 20.42 |
| Example 3-1 | 0.01 | 121.21 | 23.46 | 1.09 | 78.87 | 20.17 |
| Example 3-2 | 0.05 | 107.21 | 23.21 | 1.09 | 79.88 | 20.21 |
| Comparative Example 3-1 | 0.005 | 199.33 | 22.89 | 1.10 | 73.31 | 19.97 |
| Comparative Example 3-2 | 0.06 | 167.38 | 22.94 | 1.09 | 74.02 | 18.51 |

**Table 4 Influence of evaporation rate of the metal fluoride layer on performances of regular perovskite solar cells**

| Examples | Evaporation rate (Å/s) | Performances of perovskite solar cell | | | | |
|---|---|---|---|---|---|---|
| | | Contact resistance (ohm) | Jsc (mA·cm⁻²) | Voc (V) | FF (%) | Photoelectric conversion efficiency (%) |
| Example 2-1 | 0.02 | 73.42 | 24.57 | 1.14 | 82.47 | 23.10 |
| Example 4-1 | 0.01 | 81.20 | 24.72 | 1.14 | 81.54 | 22.98 |
| Example 4-2 | 0.05 | 76.21 | 24.55 | 1.14 | 81.82 | 22.90 |
| Comparative Example 4-1 | 0.005 | 100.21 | 24.41 | 1.14 | 79.63 | 22.16 |
| Comparative Example 4-2 | 0.06 | 152.44 | 24.50 | 1.14 | 78.45 | 21.91 |

As can be seen from Table 1 to Table 4, by disposing an ultra-thin metal fluoride layer between the electron transport layer and the perovskite light-absorbing layer, the photoelectric conversion efficiency of the perovskite solar cells in all of the above-mentioned examples are higher than that of the perovskite solar cells in the comparative examples.

As can be seen from Table 1, when the thickness of the metal fluoride layer is 1 nm-3 nm, the contact resistance of the inverted perovskite solar cells can be significantly reduced, thereby improving the photoelectric conversion efficiency of the inverted perovskite solar cells.

As can be seen from Table 2, when the thickness of the metal fluoride layer is 1 nm-3 nm, the contact resistance of the regular perovskite solar cells can be significantly reduced, thereby improving the photoelectric conversion efficiency of the regular perovskite solar cells.

As can be seen from Table 3 and Table 4, the evaporation rate of the metal fluoride also has an impact on performances of the inverted and regular perovskite solar cells. When the evaporation rate of the metal fluoride is 0.01-0.05 Å/s, the contact resistance of the perovskite solar cells can be reduced, thereby improving the photoelectric conversion efficiency of the perovskite solar cells.

It should be noted that the present application is not limited to the above-mentioned embodiments. The above-mentioned embodiments are merely exemplary examples, and embodiments that have substantially the same configuration as the technical idea and exert the same effects within the scope of the technical proposals of the present application are included in the technical scope of the present application. In addition, without departing from the scope of the present application, various modifications added to the embodiments that are conceivable by those skilled in the art, and other forms constructed by combining some components in the embodiments are also included in the scope of the present application.

## Claims

1. A perovskite solar cell, comprising: a transparent conductive glass substrate, an electron transport layer, a perovskite light-absorbing layer, a hole transport layer, and an electrode,
wherein a metal fluoride layer is disposed between the electron transport layer and the perovskite light-absorbing layer, and a thickness of the metal fluoride layer is greater than 0 and less than or equal to 3 nm, optionally 1 nm-3 nm.

2. The perovskite solar cell according to claim 1, wherein the transparent conductive glass substrate, the electron transport layer, the metal fluoride layer, the perovskite light-absorbing layer, the hole transport layer, and the electrode are sequentially arranged from bottom to top.

3. The perovskite solar cell according to claim 1, wherein the transparent conductive glass substrate, the hole transport layer, the perovskite light-absorbing layer, the metal fluoride layer, the electron transport layer, and the electrode are sequentially arranged from bottom to top.

4. The perovskite solar cell according to any of claims 1 to 3, wherein the metal fluoride layer is one or more selected from an alkali metal fluoride and an alkaline earth metal fluoride, optionally, the metal fluoride layer is one or more selected from of lithium fluoride, sodium fluoride, potassium fluoride, rubidium fluoride, cesium fluoride, magnesium fluoride, calcium fluoride, strontium fluoride, and barium fluoride.

5. A method for preparing a perovskite solar cell, comprising:
step 1: providing a transparent conductive glass substrate;
step 2: preparing an electron transport layer on the transparent conductive glass substrate;
step 3: depositing a metal fluoride layer on the electron transport layer by evaporation;
step 4: preparing a perovskite light-absorbing layer on the metal fluoride layer;
step 5: preparing a hole transport layer on the perovskite light-absorbing layer; and
step 6: preparing an electrode on the hole transport layer to obtain a perovskite solar cell,
wherein the perovskite solar cell comprises: a transparent conductive glass substrate, an electron transport layer, a perovskite light-absorbing layer, a hole transport layer, and an electrode; a metal fluoride layer is disposed between the electron transport layer and the perovskite light-absorbing layer; and a thickness of the metal fluoride layer is greater than 0 and less than or equal to 3 nm, optionally 1 nm-3 nm.

6. A method for preparing a perovskite solar cell, comprising:
step 1: providing a transparent conductive glass substrate;
step 2: preparing a hole transport layer on the transparent conductive glass substrate;
step 3: preparing a perovskite light-absorbing layer on the hole transport layer;
step 4: depositing a metal fluoride layer on the perovskite light-absorbing layer by evaporation;
step 5: preparing an electron transport layer on the metal fluoride layer; and
step 6: preparing an electrode on the electron transport layer to obtain a perovskite solar cell;
wherein the perovskite solar cell comprises: a transparent conductive glass substrate, an electron transport layer, a perovskite light-absorbing layer, a hole transport layer, and an electrode; a metal fluoride layer is disposed between the electron transport layer and the perovskite light-absorbing layer; and a thickness of the metal fluoride layer is greater than 0 and less than or equal to 3 nm, optionally 1 nm-3 nm.

7. The method for preparing a perovskite solar cell according to claim 5 or 6, wherein an evaporation rate when depositing the metal fluoride layer is 0.01-0.05 Å/s.
